# EUROPEAN PATENT SPECIFICATION

(11) **EP 3 850 122 B1**
(45) Date of publication and mention of the grant of the patent: **25.11.2026**
(21) Application number: 19773008.8
(22) Date of filing: 13.09.2019
(51) Int. Cl.: C23C 16/26, C01B 32/162, C23C 16/44, C23C 16/448

(54) **CATALYTIC CHEMICAL VAPOUR DEPOSITION**
KATALYTISCHE CHEMISCHE GASPHASENABSCHEIDUNG
DÉPÔT CHIMIQUE EN PHASE VAPEUR CATALYTIQUE

(30) Priority: 13.09.2018 GB 201814874
(43) Date of publication of application: 21.07.2021
(73) Proprietor: AGT Management & Engineering AG, 6312 Steinhausen (CH)
(72) Inventor: FUENTE-CUESTA, Aida, 6312 Steinhausen (CH); SAVANIU, Cristian, 6312 Steinhausen (CH); LENZI, Manfred, 6312 Steinhausen (CH); IRVINE, John T S, 6312 Steinhausen (CH)
(74) Representative: Marks & Clerk LLP
(86) International application number: PCT/EP2019/074581
(87) International publication number: WO 2020/053432

(56) References cited:
- JP-A- 2007 070 166
- US-A1- 2008 241 018
- US-A1- 2012 107 525
- US-A1- 2016 236 183
- YESHUI ZHANG ET AL: "Carbon nanotubes and hydrogen production from the pyrolysis catalysis or catalytic-steam reforming of waste tyres", JOURNAL OF ANALYTICAL AND APPLIED PYROLYSIS, vol. 122, 1 November 2016 (2016-11-01), NL, pages 490 - 501, XP055585720, ISSN: 0165-2370, DOI: 10.1016/j.jaap.2016.10.015

## Description

### Field of the Invention

The present invention relates to methods and apparatus for removal of CO₂ from a gas stream via a catalytic chemical vapour deposition (CCVD) process. In particular, the present invention relates to a method of processing a gas stream which reduces the CO₂ content of the gas stream, with concomitant production of carbon nanotubes (CNTs) and syngas (CO + H₂).

### Background

The replacement of fossil fuels with alternative energy sources is becoming of increasing importance, due to dwindling reserves of the formers along with environmental concerns. The use of biomass and other waste sources for energy and commodity chemical production has a major contribution to this gradual replacement. This increased utilisation, which should reach around half of the total energy demand in industrialised countries by 2050, reduces CO₂ emissions of the energy sector. Biomass can be converted into electricity, heat or fuels using a wide range of thermal, chemical and biochemical routes including fermentation, gasification, pyrolysis, liquefaction and hydrogenation. Amongst these, gasification is considered the key conversion technology in terms of efficiency.

During gasification, biomass undergoes thermal breakdown into different gas products through several overlapping processes such as drying, pyrolysis and partial oxidation. The main constituents of a gasified biomass stream are H₂, CO, CO₂, CH₄ and CₓH_{y.} The ratio of the gas products depends on the biomass composition, gasification process employed and process parameters, such as temperature. Depending on the temperature at which the gasification is performed, different compositions of the gas stream can be obtained. At low temperatures (≤750 °C), the product gas contains H₂, CO, CH₄ and other hydrocarbons, and at high temperatures (≥750 °C) it contains mainly H₂ and CO. Syngas (H₂+CO) is an important resource suitable for utilisation in fuel cells, engines and turbines or to produce synthetic natural gas (SNG) and transportation fuels.

Carbon nanotubes (CNTs) are very promising materials due to their unique chemical and physical properties, making them attractive for a broad range of applications. Until now, CNTs have been synthesized by a variety of techniques, such as arc-discharges, laser ablation, and catalytic chemical vapour decomposition (CCVD). Among these techniques, CCVD is currently considered the best approach for low-cost and large-scale synthesis of high-quality CNTs. The successful synthesis of CNTs and their subsequent properties depend on various parameters related to both catalyst and reaction conditions, such as type of carbon feedstock, temperature and space velocity.

Cost-effective supported catalysts are the key to achieving large-scale production of CNTs, and CCVD allows for a broad variability in the choice of substrate materials. Alumina is a well-known support with excellent thermal stability and high mechanical resistance, which makes it suitable in industrial catalytic applications. Stainless steel substrates such as meshes are also a readily available and economical support, which have the advantage of utilisation as either a support or a combined support-catalyst due to their chemical composition. The most commonly used catalysts for CNT production *via* CCVD are nanoparticles of Ni, Fe and Co and their alloys, as these metals present adequate carbon solubility. The size and distribution of the metal particles dispersed on the support have been found to be crucial factors which can affect the type, yield, shape and diameter of the CNTs. The use of individual hydrocarbons (CH₄, C₂H₆, C₂H₄, C₂H₂ *etc.)* for the generation of CNTs has been widely reported in literature. US2016236183 describes a catalyst and the process for obtaining it that has a higher resistance to the deposition of coke on the catalyst surface.

US2012107525 describes a device which uses CO2 in exhaust gases as a carbon source and immobilises the carbon (C) in the CO2 to create an advanced carbon fuel in the form of useful, high added-value nanocarbon structures such as multi-layer carbon-nanotubes, carbon-onions or the like, and which also reduces the quantity of the CO2 contained in exhaust gases that is emitted into the atmosphere. A reactor is provided with at least: a substrate upon the surface whereof a catalyst layer of iron or the like is formed; a heat source means for heating the substrate; a gas introducing means for introducing carbon oxide containing gas onto the surface of the substrate; a microwave plasma generation means for generating microwave plasma on the surface of the substrate; and a power supply means, for the generation of microwave plasma. The heat source means uses exhaust heat from the front muffler of a car, the power supply means uses an on-board car battery and microwave plasma CVD is used to create multi-layer carbon-nanotubes, carbon-onions or the like on the surface of the substrate, using the CO2 within car exhaust gases as a carbon source. Further relevant prior art is disclosed in JP 2007 070166 A and in the article from YESHUI ZHANG ET AL: "Carbon nanotubes and hydrogen production from the pyrolysis catalysis or catalytic-steam reforming of waste tyres", JOURNAL OF ANALYTICAL AND APPLIED PYROLYSIS, vol. 122, 1 November 2016 (2016-11-01), pages 490-501, XP055585720,NL ISSN: 0165-2370, DOI: 10.1016/j.jaap.2016.10.015.

The present invention has been devised with these issues in mind.

### Summary of the Invention

The present invention is defined in the independent claims. Some preferred features are defined in the dependent claims.

According to a first aspect of the invention there is provided a method for processing a gas stream produced by gasification of biomass or waste or by Low Temperature Conversion, LTC, wherein the LTC is carried out at a temperature of 600°C or less, the gas stream comprising 1-60 vol.% CO2 ; 1-60 vol.% CO; 1-40 vol.% H2 ; 1-80 vol.% CH4 ; 0-35 vol.% n-C2 - n-C6 ; 0-45 vol.% N2 ; 0-5 vol.% 02 ; 0-20 vol.% H2 O, the method comprising:processing the waste using the Low Temperature Conversion, LTC, to produce an output gas using an LTC system, or performing the gasification of biomass or waste to produce an output gas using a gasification system;supplying the gas stream output from the LTC or the gasification to CCVD apparatus;utilising the gas stream in a catalytic chemical vapour deposition, CCVD, process, thereby reducing the CO2 content of the gas stream and concomitantly producing carbon nanotubes and syngas, the CCVD process being carried out at a temperature of from 500°C to 900°C, and wherein the catalyst is catalyst is a stainless steel or alumina supported catalyst, the catalyst comprising a metal, metal alloy or an enriched metal in an oxide layer, and wherein the catalyst has a metal loading of from 0.1 to 30 wt%, relative to the total weight of the metal and the support;n-C2 - n-C6 comprises at least one of: ethane, ethane, ethyne, propane, propene, propyne, butane, butane, butyne, pentane, pentene, pentyne, hexane, hexane or hexyne, or any combination thereof; and whereinthe CCVD process is carried out at the same temperature as the gasification or LTC process.

In addition to reducing the CO₂ content of the gas stream, the process results in the production of carbon nanotubes (CNTs) and syngas (CO + H₂).

In some embodiments the gas stream comprises from 5 to 50 vol.%, from 10 to 35 vol.% or from 15 to 25 vol.% CO₂.

The gas stream may comprise from 10 to 50 vol.%, or from 20-35 vol.% CO.

The gas stream may comprise from 5 to 30 vol.% or from 10 to 20 vol.% H₂.

The gas stream may comprise from 5 to 60 vol.%, from 10 to 40 vol.% or from 15 to 20 vol.% CH₄.

In some embodiments, the gas stream comprises from 5 to 45 vol.%, from 10 to 40 vol.%, or from 15 to 30 vol.% N₂.

In some embodiments, the gas stream comprises from 1 to 4 vol.% O₂.

The gas stream may comprise from 1 to 18 vol.% or from 2 to 15 vol.% H₂O.

In some embodiments the gas stream comprises hydrocarbons having two or more carbon atoms. The gas stream may comprise n-C₂, n-C₃, n-C₄, n-C₅ and/or n-C₆ hydrocarbons. The hydrocarbons comprise ethane, ethane, ethyne, propane, propene, propyne, butane, butane, butyne, pentane, pentene, pentyne, hexane, hexane or hexyne, or any combination thereof.

In some embodiments, the total concentration of n-C₂, n-C₃, n-C₄, n-C₅ and/or n-C₆ hydrocarbons present in the gas stream may be from 1 to 20 vol.% or from 5 to 15 vol.%.

In some embodiments, the gas stream comprises a mixture of at least 4, at least 5, at least 6, at least 7, at least 8 or at least 9 gases.

According to the present invention the gas stream comprises:
1-60 vol.% CO₂
1-60 vol.% CO
1-40 vol.% H₂
1-80 vol.% CH₄
0-35 vol.% n-C₂- n-C₆
0-45 vol.% N₂
0-5 vol.% O₂
0-20 vol.% H₂O (vapour)

In some further embodiments, the gas stream comprises:
10-35 vol.% CO₂ (e.g. 15-25 vol.%)
10-50 vol.% CO (e.g. 20-35 vol.%)
5-30 vol.% H₂ (e.g. 10-20 vol.%)
5-60 vol.% CH₄ (e.g. 10 to 40 vol% or 15-20 vol.%)
1-20 vol.% n-C₂- n-C₆ (e.g. 5-15 vol.%)
15-40 vol.% N₂ (e.g. 20-30 vol.%)
0-4 vol.% O₂ (e.g. 1-3 vol.%)
0-18 vol.% H₂O (vapour) (e.g. 2-15 vol.%)

In some embodiments the gas stream comprises H₂, N₂, CO, CO₂, CH₄ and one or more n-C₂ hydrocarbons (e.g. ethane, ethene and/or ethyne). The gas stream may further comprise one or more gases selected from O₂, H₂O, a n-C₃ hydrocarbon, a n-C₄ hydrocarbon, a n-C₅ hydrocarbon and a n-C₆ hydrocarbon.

In some embodiments the gas stream comprises H₂, O₂, N₂, H₂O, CO, CO₂, CH₄, n-C₂ and n-C₃ hydrocarbons.

In some embodiments, the ratio of H₂/CO in the gas stream is from 0.05-0.2 or from 0.07 to 0.1.

It will be understood that the gas stream may contain small amounts of other gases, such as sulphur-containing volatile compounds.

The present invention utilises a gas stream comprising a mixture of gases in a CCVD process. This produces two valuable products; carbon nanotubes and syngas (CO + H₂). Surprisingly it has been found that CNTs can be produced via CCVD using a gas stream comprising a more complex mixture of gases, such as that which may be produced by an industrial process (e.g. gasification of biomass). It is particularly surprisingly that the CNTs produced from the complex gas stream have sufficient quality for practical applications, and are at least comparable to those obtained using single gases. In addition, the process achieves a reduction in CO₂ content of the gas stream which is beneficial from both an industrial and environmental perspective.

The gas stream used in the CCVD process of the invention may be derived from an industrial process.

In some embodiments, the gas stream is produced by gasification of a waste material. Any waste material may be used, such as plastics, tires, municipal wastes, waste from water treatment, and biomass. As is known in the art, "gasification" is a process that converts carbonaceous materials into gases including CO, CO₂, H₂ and, depending on the temperature at which the process is carried out, various hydrocarbons. It will therefore be appreciated that the composition of the gas stream will depend on the waste material and the process used to generate it.

In some embodiments, the waste material is gasified at a temperature of no more than 800°C, no more than 750°C, no more than 650 °C or no more than 600°C.

According to the present invention the method further comprises the step of gasifying a waste material to produce a gas stream, and using the gas stream in the CCVD process to produce CNTs. The gas stream may be supplied directly to the CCVD process, without any intermediate processing.

According to the present invention the gas stream is produced by Low Temperature Conversion (LTC). As is known by those skilled in the art, the LTC process involves pyrolysis of waste materials at temperatures typically below 600°C, generating liquid products (including pyrolysis oil, which is a mixture of hydrocarbons, fatty acids and aromatic compounds) and gases.

According to the present invention the method further comprises the step of processing a waste material using Low Temperature Conversion to produce an output gas, and using the output gas as the gas stream in the CCVD process. An example LTC process is described in WO1997/001616 and in AT 502146 A1.

The LTC is carried out at 600°C or at less than 600°C, less than 550°C, less than 500°C or less than 450°C.

Thus, according to a second aspect of the invention, there is provided the use of a gasified waste stream or a LTC gas stream in a catalytic chemical vapour deposition process.

According to a third aspect, the invention provides a method for producing carbon nanotubes, the method comprising carrying out a catalytic chemical vapour deposition process using a gasified waste stream or a LTC gas stream.

In some embodiments the gasified waste stream is a gasified biomass stream.

It will be understood that a "gasified biomass stream" is the output gas from the gasification of biomass. It will further be understood that a "LTC gas stream" is the output gas from a LTC process.

In another aspect, the invention provides a method of processing a gasified biomass stream or a LTC gas stream, comprising carrying out a catalytic chemical vapour deposition process using the gasified biomass stream or the LTC gas stream, thereby producing carbon nanotubes and syngas.

The CCVD process comprises passing the gas stream through a catalyst placed in a reactor. The reactor may be a fixed-bed reactor, or a fluidized bed reactor.

The CCVD process is carried out at a temperature of from 500°C to 900°C, from 550°C to 850°C, from 600°C to 800°C or from 650°C to 750°C.

In some embodiments the catalyst is pre-heated to the reaction temperature prior to passing the gas stream through the catalyst. The step of pre-heating the catalyst may be carried out in an inert atmosphere (e.g. N₂ or Ar), or in an atmosphere comprising H₂ (e.g. 5% H₂/Ar). An inert atmosphere may be used where the catalyst is pre-reduced. An atmosphere comprising H₂ may be used if it is required to reduce the catalyst *in-situ.* The catalyst may alternatively be reduced *in-situ* by the gas stream, without the need for *ex-situ* or *in-situ* reduction with H₂.

It will be appreciated that some of the parameters of the CCVD process will depend on a number of variables (such as the reactor size, the amount of catalyst and the quality and volume of gas being processed), and that these parameters can be adjusted by the skilled person accordingly.

The reaction time (i.e. the duration of the CCVD process) may be from 100 milliseconds (ms) to 5 hours. In some embodiments the reaction time is from 1 minute to 4 hours, from 10 minutes to 3 hours, or from 30 minutes to 2 hours.

The space velocity may be from 400 to 700 or from 500 to 600 h⁻¹. However, in some processes the space velocity could be up to 20000 h⁻¹.

The CCVD process uses a catalyst. The catalyst is a supported metal catalyst. Suitable metals include nickel, iron, molybdenum, manganese, cobalt, copper, ruthenium, rhodium, palladium, iridium, platinum, chromium, tungsten, cerium, silver, gold, or mixtures or alloys thereof (e.g. steel). The metal may be in the form of nanoparticles. Suitable supports include stainless steel (e.g. in the form of a mesh) and alumina.

In some embodiments the process uses a stainless steel supported catalyst.

A stainless steel supported catalyst may be prepared by an oxidation-reduction treatment of a stainless steel substrate (e.g. a stainless steel mesh), thereby forming metal nanoparticles on a surface of the steel.

Alternatively, a stainless steel supported catalyst may be a coated stainless steel supported catalyst. A stainless steel supported catalyst may be prepared by coating (e.g. dip-coating) a pre-oxidised or raw stainless steel substrate in a solution comprising metal (e.g. nickel) ions. This results in the deposition of metal nanoparticles on the steel surface. One, two, three or more coatings may be applied.

The solution may comprise a metal salt in a solvent, such as an alcohol (e.g. ethanol). In some embodiments the solution further comprises a surfactant. The surfactant may be present in an amount of from 1 to 20 wt.%, from 2 to 8 wt.% or from 3 to 5 wt.%. In some embodiments the solution further comprises terpineol.

The loading of the metal on the stainless steel supported catalyst is from 0.1 to 30 wt%, from 0.5 to 20 wt% or from 1 to 10 wt%. In some embodiments, the metal loading is from 0.1 to 1.1 wt%, from 0.2 to 0.8 wt% or from 0.3 to 0.6 wt%, relative to the total weight of the metal and the support.

It will be understood that, in the case of coated stainless steel supported catalysts, the "metal loading" is the metal content of the coating which is applied to the stainless steel substrate.

The solution may further comprise a surfactant and, optionally terpineol.

Following coating, the stainless steel supported catalyst may be calcined (e.g. in air at from 400-500°C). The calcined catalyst may then be reduced (e.g. in H₂/Ar at 600-800°C).

In some embodiments an alumina support is impregnated with from 1 to 30 wt%, from 2 to 20 wt%, from 2.5 to 10wt% or from 5 to 8 wt% of a metal catalyst (e.g. Ni). For example, the support may be impregnated with 10 wt% Ni.

In other embodiments, an alumina support may be impregnated with from 1 to 30 wt%, from 2 to 20 wt%, from 2.5 to 10wt% or from 4 to 6 wt% of a bi-metallic catalyst (e.g. Ni-Mo). For example, the support may be impregnated with 5 wt% Ni-Mo (4 wt% Ni and 1 wt% Mo).

In some embodiments, the method further comprises removing the CNTs from the supported catalyst. The CNTs may be detached from the catalyst support by any suitable method, for example shaking, vibrating or using ultrasonication.

In some embodiments, the method further comprises purifying the CNTs, after they have been removed from the supported catalyst. The skilled person will be aware of various methods for purifying CNTs, and will be able to select an appropriate method depending on the application. For example, purification may be carried out by combustion (i.e. of the amorphous carbon I, for example, air), or by washing in an acid or alkali solution.

According to a further aspect of the invention, there is provided an apparatus for processing a gas stream produced by gasification of biomass or waste or by Low Temperature Conversion, LTC, wherein the LTC is carried out at a temperature of less than 600°C, the gas stream comprising 1-60 vol.% C02 ; 1-60 vol.% CO; 1-40 vol.% H2 ; 1-80 vol.% CH4 ; 0-35 vol.% n-C2 - n-C6 ; 0-45 vol.% N2 ; 0-5 vol.% O2 ; 0-20 vol.% H2 0, the apparatus comprising:a catalytic chemical vapour deposition, CCVD, reactor for carrying out a CCVD process and receiving a catalyst therein, the reactor having a gas inlet and a separate gas outlet and configured for reducing the CO2 content of the gas stream and concomitantly producing carbon nanotubes and syngas;a heat source for heating the reactor to a temperature of from 500°C to 900°C;a supply of the gas stream in fluid communication with an outlet of a gasification or LTC system;a catalyst in the reactor, wherein the catalyst is a stainless steel or alumina supported catalyst, the catalyst comprising a metal, metal alloy or an enriched metal in an oxide layer, and wherein the catalyst has a metal loading of from 0.1 to 30 wt%, relative to the total weight of the metal and the support;anda gas control system which controls the supply of the gas stream to the gas inlet of the reactor, and whereinn-C2 - n-C6 comprises at least one of: ethane, ethane, ethyne, propane, propene, propyne, butane, butane, butyne, pentane, pentene, pentyne, hexane, hexane or hexyne, or any combination thereof; andthe apparatus is configured such that the CCVD process is carried out at the same temperature as the gasification or LTC process.

In some embodiments the gas stream is produced by gasification of a waste material, such as biomass, as described herein. In some embodiments the gas stream is produced by Low Temperature Conversion (LTC), also as described herein.

According to the present invention an output of a gasification or LTC process directly supplies the gas stream to the apparatus. Thus, according to the present invention the supply of the gas stream is in fluid communication with the outlet of a gasification or LTC system.

For example, a conduit may link the gasification system or LTC system to the apparatus of the present invention.

In addition to the gas stream, the apparatus may further comprise a supply of one or more other gases, such as air, argon, nitrogen, hydrogen and mixtures thereof (e.g. H₂/Ar). In some embodiments, the apparatus further comprises a gas mixing panel.

The heat source may be a furnace inside which the reactor is placed. A controller may be provided for controlling the furnace, such as a PID controller.

The apparatus may further comprise a temperature control system for monitoring and controlling the temperature inside the reactor. The temperature control system may comprise a thermocouple.

According to the present invention the reactor contains a catalyst. Suitable catalysts are described herein.

It will be understood that any of the embodiments described above may be combined with any other embodiment and with any aspect of the invention, unless otherwise stated.

### Description of the Figures

Embodiments of the invention will now be described by way of example and with reference to the Figures, in which:
Figure 1 is a schematic of an apparatus for use in the CCVD process;
Figure 2 shows the results of the EDX analysis of a stainless steel mesh treated by oxidation-reduction;
Figure 3 shows SEM micrographs of a stainless steel mesh pre-oxidised at 800°C for 15 minutes and dip-coated in different precursor solutions, followed by reduction;
Figure 4 is a graph showing the nanoparticle size distribution of a reduced γ-alumina supported catalyst (10 wt.% Ni);
Figure 5 shows graphs showing the evolution of the gas components from a gas mixture with time at 800°C in the presence of (a) oxidised-reduced stainless steel mesh (800C-SS316), (b) dip-coated stainless steel mesh (Ni-ES-SS316) and (c) impregnated alumina (Ni-Al2O3);
Figure 6 shows SEM micrographs of the carbon deposits obtained during the CCVD process with the biomass gasification mixture at 800 °C in presence of (a) an oxidised-reduced stainless steel mesh (800C-SS316), (b) a dip-coated stainless steel mesh (Ni-ES-SS316) and (c) an impregnated alumina (Ni-Al₂O₃) catalyst;
Figure 7 shows TEM (a) and HRTEM (b) micrographs illustrating features of the un-purified CNTs obtained during the CCVD process with the biomass gas mixture at 800°C in presence of the different catalysts;
Figure 8 shows the nanoparticle size distribution of a reduced bi-metallic γ-Al₂O₃ supported catalyst (5 wt.% Ni-Mo); and
Figure 9 shows graphs showing the evolution of the gas composition from a biomass gas stream over time at (a) 600°C and (b) 800°C in presence of the bi-metallic γ-Al₂O₃ supported catalyst (5 wt.% Ni-Mo).

### Example 1

### Experimental

### Materials synthesis.

**Stainless steel supported catalysts.** A commercial 316L stainless steel mesh (Dexmet Corporation, 4SS(316L) 7-100AN x 8.875") was thermally and chemically modified to obtain a set of optimised materials for CCVD testing. The as-specified chemical composition of the mesh used in this work can be seen in Table 1. Prior to further treatment, the meshes were cleaned in an ultrasonic bath with acetone. The formation of metal nanoparticles on the surface from its intrinsic Ni (10-14%) and Fe (≥62%) content was evaluated *via* a simple and inexpensive oxidation-reduction treatment. A second synthesis route to deposit additional metal nanoparticles on the stainless steel mesh was assessed *via* dip coating.

**Table 1. Chemical composition of the 316L stainless steel mesh.**

| **316L Chemical composition (%)** | | | | | | | | | |
|---|---|---|---|---|---|---|---|---|---|
| **C** | **Mn** | **P** | **S** | **Si** | **Cr** | **Ni** | **Mo** | **Cu** | **Fe** |
| ≤0.03 | ≤2 | ≤0.04 | ≤0.03 | ≤1 | 16-18 | 10-14 | 2-3 | ≤0.75 | Balance |

**Oxidation-Reduction (O-R).** The stainless steel mesh was oxidised in static air and afterwards reduced in 5% H₂/Ar. Different temperatures and dwell times for each step were evaluated. The lowest oxidation temperature assessed was 600°C. At this temperature, the oxidation step was carried out for 1 h and the subsequent reduction step was performed at 600, 700 or 800°C for a fixed time of 2 h. At higher oxidation temperatures, 700 and 800°C, different dwell times were studied - 1 h, 15 min and no dwell. The reduction temperature was then maintained at 800°C and dwell times of 2 h, 1 h, 30 min and no dwell were studied. A maximum oxidation and reduction temperature of 800°C was established, as previous studies have reported brittleness issues when exceeded, which adversely affects handling and processing. The ramp rate used for the oxidation and reduction processes was fixed at 10°C/min.

**Dip coating.** The dip coating process was applied to two pre-oxidised meshes, treated at 600°C for 1 h or 800°C for 15 min. Pre-oxidised meshes were used as their surface roughness facilitates the adherence of the catalyst compared to the smooth surface of the raw mesh. Initially, an ethanol-based solution of 0.5 M nickel nitrate (Ni(NO₃)₂·6H₂O, Acros Organics) was used. The solution was then modified by the addition of 3 or 5 wt.% of a surfactant, hexadecyltrimethyl ammonium bromide (CTAB, Acros Organics). This improves the quality of the coating by reducing the surface tension of the solution, improving the nickel dispersion and avoiding agglomeration. A further modification of the media was carried out by the addition of terpineol (1:2 ethanol to terpineol by volume) in presence of 5 wt.% CTAB, in order to increase the viscosity of the solution and enhance adherence to the substrate. The need for single or multiple coating steps with the different solutions on each substrate was evaluated. The coating speed was controlled to approximately 6 cm·min⁻¹.

Following dip coating, the meshes were calcined in air at 450°C for 2 h and reduced in 5% H₂/Ar at 800°C for 1 h. The ramp rate for heating and cooling during calcination was 3 °C/min and for reduction 10 °C/min.

**γ-alumina supported catalyst.** Table 2 shows a summary of the as-specified textural properties of the commercial γ-Al₂O₃ used as powder support in this work.

For the powder substrate, a study to identify the best impregnation procedure was undertaken as previously for the stainless steel mesh. Nickel metal was incorporated onto the alumina support *via* incipient wetness impregnation. The nickel nitrate precursor was dissolved in ethanol and the γ-Al₂O₃ was then added to this solution and dispersed for 1 h using an ultrasonic probe. Afterwards, a (i) slow and a (ii) quick evaporation of the solvent were evaluated. After evaporation, samples were calcined then reduced or reduced directly.

**Table 2. Textural properties of the commercial γ-Al₂O₃ support.**

| **Support** | **S_{BET} (m²/g)** | **Particle size (mm)** |
|---|---|---|
| Alfa Aesar | 80-120 | < 3 |

The calcination, when applied, was carried out in air at 450°C for 2 h. The reduction was performed in 5% H₂/Ar at 800 °C for 1 h. A ramp rate of 3 °C/min for calcination and 5°C/min for reduction were applied. Nickel loadings of 2.5, 6.5 and 10 wt.% were assessed.

### Materials characterisation.

Particle size analysis was carried out with a Malvern Instruments Mastersizer 2000. The surface morphology of the catalysts was examined with an FEI Scios Dualbeam FIB-SEM, which combines high resolution scanning electron microscope (SEM) with the ability to mill and image a sample using a focused ion beam (FIB). Lamellae of the stainless steel supported catalysts were prepared using the FIB-SEM to selectively image the cross sections of these materials. These lamellae, the alumina supported catalysts and the CNTs were also analysed with a Titan Themis 200 scanning transmission electron microscope (STEM). Compositional analyses of the different catalysts were carried out in the Titan Themis with a Super-X EDX detector. Metal nanoparticle size distributions and CNTs diameters were determined with the SEM and TEM/HRTEM micrographs using ImageJ software. The as-obtained carbon deposits were also examined with a Raman InVia microscope using a 514 nm laser from 100 to 3600 cm⁻¹. All measurements were carried out with constant laser output power (0.5 mW) and integration time (25s/1scan for full spectra and 15s/15scans for the D, G and G prime regions). The Raman spectra were collected in at least two different positions.

Analysis of the exhaust gas composition was undertaken using a Shimadzu GC-2014 micro gas chromatograph, equipped with flame ionisation (FID) and thermal conductivity (TCD) detectors in series. The GC method for gas separation utilised two packed columns - a Hayesep N and 3Å molecular sieve in series, and was run isothermally at 50°C. The carrier gas used was nitrogen at a flow rate of 30 mL·min⁻¹.

Permanent gases (O₂, H₂, CO₂ and CO) were measured by TCD, and hydrocarbons (CH₄, C₂H₄ and C₂H₆) by FID to improve detection at low concentrations. The final method was calibrated using a gas mixture (+/- 2% on quoted values) diluted with nitrogen in varying ratios to obtain calibration curves with at least five data points and confidences of > 99% (R > 0.99). Calibration points were performed three times each to ensure repeatability. A separate analysis was undertaken to ensure increases of flow rate do not adversely affect concentration of the components. Samples were injected at intervals of 20 minutes by flowing the exhaust gas through the sample loop.

### Catalytic chemical vapour deposition set-up.

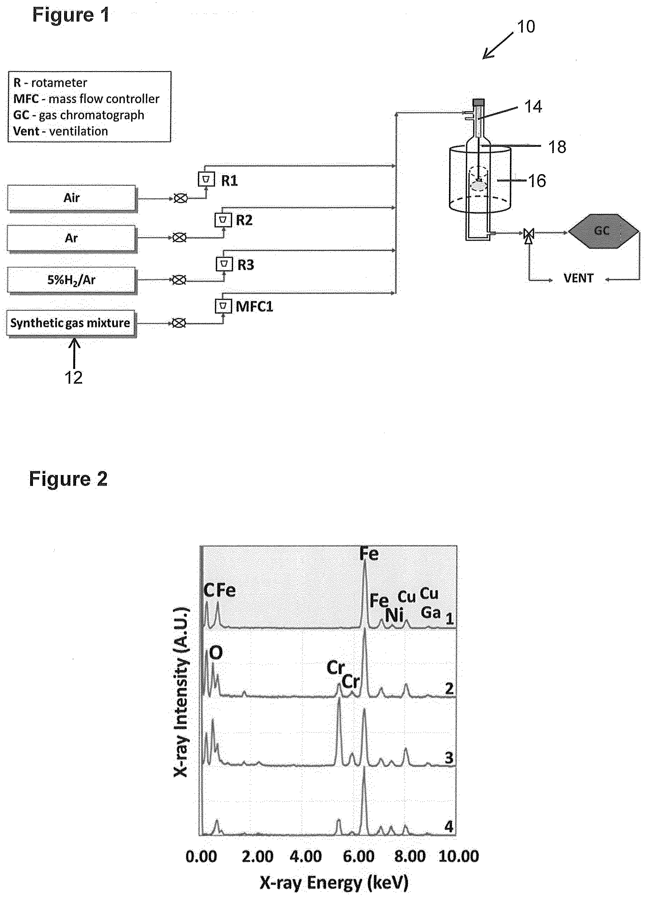

Figure 1 shows a schematic of the lab-scale apparatus (10) built to carry out the CCVD process. The apparatus consisted of four main parts: (i) a gas mixing panel (12), (ii) a fixed-bed reactor (14), (iii) a furnace (16) with a PID controller and (iv) a gas chromatograph (GC) to analyse the gas composition at the outlet of the reactor. The catalyst of study was placed in the fixed-bed reactor, which consisted of two concentric quartz tubes. The stainless steel mesh supported catalyst was rolled in a cylindrical configuration and fitted in the inner quartz tube, whereas the alumina catalyst was supported between quartz wool in the external quartz tube. For the CCVD tests, around 5.5 g of stainless steel mesh or 1.6 g of impregnated alumina were used. The quartz reactor containing the catalyst was fitted into a furnace and the temperature in the catalyst bed was controlled *via* an external thermocouple (18) inserted from the top of the reactor.

For the CCVD testing, the catalyst was heated up to the testing temperature in an inert atmosphere (N₂ or Ar) when it was pre-reduced, or in 5%H₂/Ar if the reduction process was carried out *in-situ.* Once the desired temperature was reached or after carrying out the reduction, a gas mixture simulating the gas composition from a biomass gasification plant was passed through the catalyst. This dry gas mixture contains a total of seven species, H₂, CO, CO₂, N₂, CH₄, C₂H₆ and C₂H₄. A temperature interval of 600-800 °C was initially selected as the optimum for the CCVD process, considering the gas and solid products of interest and the known temperature of the gas stream from the gasification plant. The use of the same temperature at all stages can simplify the integration of the process at higher scales and decrease the thermal fatigue of the materials.

The gases at the outlet of the reactor were analysed by GC. Any water vapour present in the gas outlet was condensed in a cold trap before GC measurement. After testing, the reactor was cooled down in an inert atmosphere.

The carbon deposits on the stainless steel supported catalysts were characterised before removing them from the mesh. The recovery consisted of shaking followed by two cycles of ultrasonication of 30 min per cycle. The ultrasonication was carried out with an ultrasonication probe in ethanol (0.3-0.4 cycles and 30-40% amplitude). The carbon deposits from the Ni-alumina catalyst were characterised without any additional separation or purification step.

In this work, the type and concentration of the carbon precursor(s) and carrier gas(es) were defined by the composition of the biomass process gas stream. The temperature to carry out the CCVD process was set to 800°C, the flow rate of the gas mixture simulating the composition from the biomass plant was 50 ml·min⁻¹ and the time of reaction was fixed at 2 h. In these conditions, the space velocity was ~ 450 or 630 h⁻¹ when stainless steel mesh or impregnated alumina was used as catalyst, respectively. With these experimental conditions fixed, it was possible to assess the suitability of the different catalysts for the upgrade of the biomass gas stream to syngas and carbon nanotubes.

### Results and Discussion

### Materials characterisation.

**Oxidation-Reduction (O-R).** The oxidation of the 316L stainless steel mesh at 600°C for 1 h followed by a reduction at 600°C for 2 h in 5% H₂/Ar produced a particulate surface morphology. For a fixed reduction dwell time of 2 h, an increase of the temperature resulted in increased agglomeration of the nanoparticle-like sites *(i.e.* up to 1 or 3 µm at 700 or 800°C, respectively) and broader particle size distributions. The oxidation at higher temperatures - 700 or 800°C - for 1 h and reduction at any temperature between 600 and 800°C led to a different morphology. A percolated structure consisting of submicron grains, decorated with nanoparticles on the surface was observed. To achieve a similar morphology to the samples treated at 600°C, the oxidation time was reduced. When the mesh was oxidised at 800°C for 15 min and reduced at 800°C for 1 h a particulate morphology was also observed.

Based on the observed favoured microstructures, the sample oxidised at 600°C for 1 h then reduced at 600°C for 2 h, and the one oxidised at 800°C for 15 min then reduced at 800°C for 1 h were selected for further characterisation. Two different regions were observed in the micrographs - the bulk of the steel along with a thin surface layer. This surface layer is thinner when the mesh was treated at lower temperature.

Further investigation of the lamellae of the meshes was undertaken with TEM and EDX analysis. Figure 2 shows the results of the EDX analysis of four areas of interest of a cross section of the mesh oxidised-reduced at the lowest temperature (600°C_1h-600°C_2h). The Cu and Ga peaks in the EDX spectra are due to the TEM grid and the Ga beam used to cut the lamella in the FIB-SEM, respectively. Area 4 is representative of the bulk of the steel, and contains mainly Fe, Cr and Ni. In areas 2 and 3, the O level increases compared to the bulk of the steel. This indicates that the region represented by areas 2 and 3 is a thin oxide layer which was created during the oxidation step. Finally, region 1 is representative of a metal nanoparticle. In this area, only signals of Fe and Ni were detected. The average composition of the metal nanoparticles according to the EDX analyses was 94% Fe and 6% Ni, with sizes ranging from 24 to 76 nm.

The conclusions from TEM and EDX analyses undertaken on the mesh treated at the higher temperature, 800°C_15min-800°C_1h, are similar to the ones obtained with the mesh thermally treated at 600 °C. A distinctive feature found on the cross section of the mesh treated at higher temperature were some enriched metallic regions (85% Fe:15% Ni) embedded in different areas of the oxide layer. The metal nanoparticles were found to consist of 92% Fe and 8% Ni on average, with sizes ranging from 21 to 51 nm.

Therefore, the metal nanoparticles created by oxidation-reduction treatments are Fe-Ni alloys. These nanoparticles would be the active sites for CNT growth.

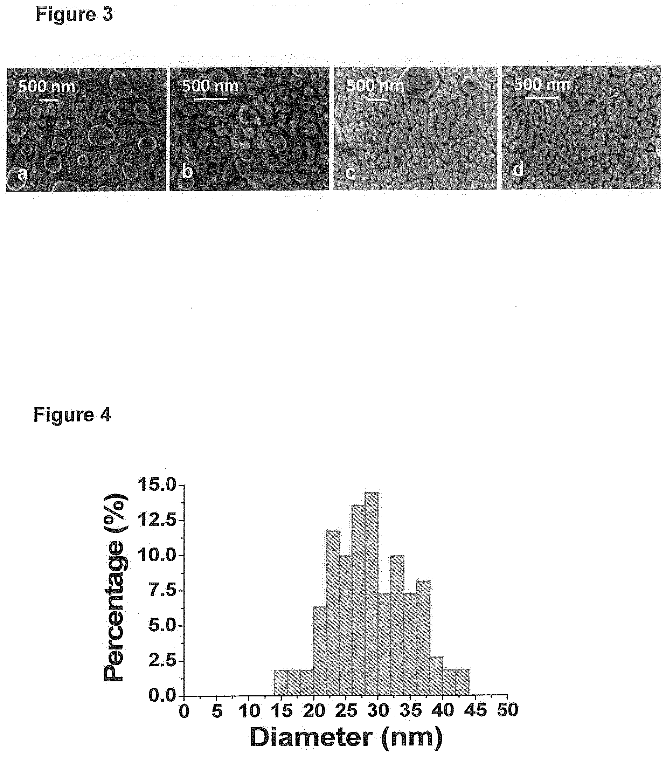

**Dip coating.** Similar results in terms of total loading, coverage and particle size distribution were found when performing the dip coating on either pre-oxidised meshes at 600°C for 1 h or at 800°C for 15 min. Consequently, a summary of the main findings with the pre-oxidised material at 800°C for 15 min are shown in Figure 3, which shows the SEM micrographs after reduction.

A single coating of the pre-oxidised mesh in an ethanol-based solution of nickel nitrate did not provide homogeneous coverage. Multiple coatings were therefore required. With three coatings, a more homogenous coverage was observed after calcination. However, the SEM micrograph of this material after reduction (Fig. 3 (a)) showed agglomeration of the metal nanoparticles. With the addition of 3 wt.% CTAB surfactant, two coatings were still needed to obtain homogeneous coverage of the mesh surface (Fig. 3 (b)). Moreover, a wide distribution of Ni nanoparticles and the presence of some agglomerates were still observed after reduction (Fig. 3 (b)). The increase from 3 to 5 wt.% CTAB surfactant helped to achieve homogeneous coverage with a single coating. In this case, 0.31 wt.% Ni was coated on the mesh surface. The SEM micrographs after reduction (Fig. 3 (c)) showed an even Ni nanoparticle size distribution. The addition of terpineol to the solution with 5 wt.% surfactant increased the viscosity of the solution and its adherence to the mesh and, therefore, increased the Ni content impregnated after a single coating. In this scenario, the amount of Ni increased from 0.31 wt.% to 0.54 wt.%. The SEM micrographs of this sample still show homogenous coverage after calcination and a consistent Ni nanoparticle distribution after reduction (Fig. 3 (d)).

Upon observing the microstructures obtained after surface modification *via* dip coating, the pre-oxidised 800°C_15min and single coated in ethanol or ethanol:terpineol nickel nitrate solutions containing 5 wt.% surfactant meshes were selected for catalytic testing.

**γ-alumina supported catalyst.** During the evaporation of the solvent after powder impregnation, it was observed that a quick evaporation of the ethanol reduced agglomeration of alumina particles. This was confirmed by particle size analyses of samples prepared with the different nickel loadings *(i.e.* with a 2.5 wt.% Ni, for slow evaporation d(0.5) and d(0.9) were 9.7 and 79 µm, respectively; whereas for quick evaporation d(0.5) and d(0.9) were 6.3 and 31 µm, respectively). The need for the second step of the synthesis, the calcination of the nickel nitrate, was evaluated for samples loaded with 6.5 wt.% Ni. TEM analysis showed that a direct reduction of the material *(i.e.* without a calcination step) did not lead to a significant increase in the Ni nanoparticle size distribution *(i.e.* 5 to 13 or 14 nm with both distributions centred around 8-9 nm, after reduction at 800 °C with no dwell). The studies also showed that an increase in the metal loading led to an increase in the agglomeration of the alumina particles (probably *via* agglomeration in the precursor solution) and an increase of the nickel nanoparticle sizes when all other experimental parameters remained constant.

According to these findings, a sample with 10 wt.% Ni was produced for CCVD testing following a procedure with a quick evaporation of the ethanol and a direct reduction at 800°C for 1 h. For this material, the d(0.5) was ~24.5 µm and d(0.9) ~143 µm. This sample was analysed by TEM. The TEM micrograph displayed a good distribution of the Ni nanoparticles on the alumina support. The Ni nanoparticle size distribution is shown in Figure 4. There is a narrow Ni distribution with a mean diameter around 25-30 nm. The nanoparticle size distribution can be tailored by controlling the reduction temperature or dwell time for a fixed Ni loading.

**Summary of materials selected for CCVD testing.** In Table 3 a summary of the materials selected for CCVD testing is presented, along with their synthesis routes and the abbreviation by which they will be referred subsequently.

**Table 3. Codes of the materials selected as catalysts for CCVD process to upgrade the biomass gas stream to syngas and CNTs together with a description of their synthesis route.**

| **Support** | **Synthesis route** | **Description** | **Code** |
|---|---|---|---|
| **316L SS mesh** | Oxidation-Reduction | 600°C_1h-600°C_2h | 600-SS316 |
| | | 800°C_15min-800°C_1h | 800-SS316 |
| **Pre-oxidised 800°C_15min 316 SS mesh** | Dip coating | 0.31wt.%Ni_E_CTAB | Ni-ES-SS316 |
| **γ-Al₂O₃** | Incipient wetness impregnation | 0.54wt.%Ni_E:T_CTAB | Ni-ETS-SS316 |
| | | 10wt.%Ni_Al₂O₃ | Ni-Al₂O₃ |

| | | | |
|---|---|---|---|
| SS: stainless steel; E: ethanol; S:surfactant=CTAB; T: terpineol | | | |

### Catalytic chemical vapour deposition testing.

In the following sections, the composition of the exhaust gas stream and the type and quality of carbon deposits obtained *via* CCVD with the five selected catalysts listed in Table 3 are discussed. The tests were performed with 50 ml·min⁻¹ of the biomass gasification mixture at 800°C during 2 h.

### Gas phase analysis.

Both oxidised-reduced meshes (600C-SS316 and 800C-SS316) and dip-coated meshes (Ni-ES-SS316 and Ni-ETS-SS316) exhibited similar behaviour in terms of gas conversion.

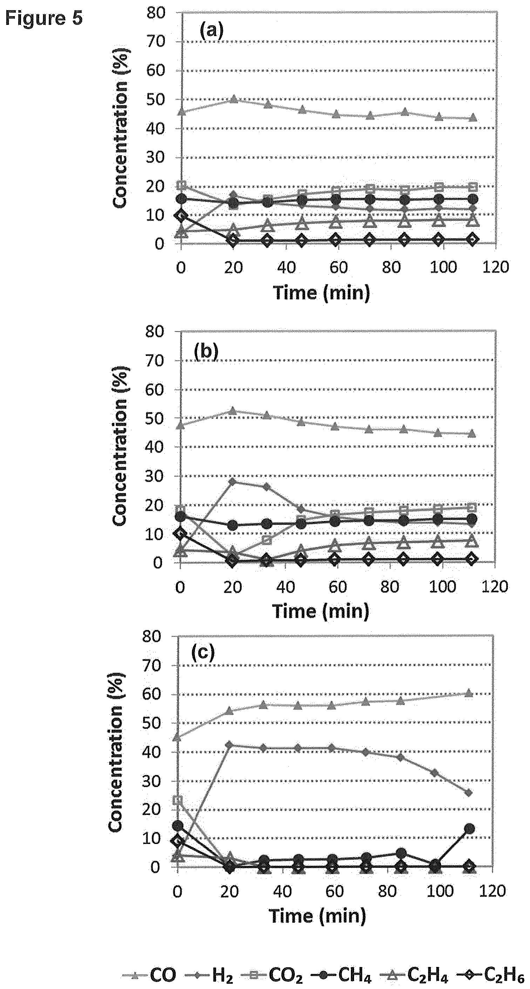

Figure 5 shows the concentrations of the balanced gas components (disregarding nitrogen) over time, in presence of the different types of catalysts, (a) 800C-SS316, (b) Ni-ES-SS316 and (c) Ni-Al₂O₃. The concentrations presented at time zero are those of each gas component measured before heating to 800°C. When the oxidised-reduced or dip-coated meshes were tested as catalysts (Fig. 5 (a-b)), the C₂H₆ concentration decreased to almost negligible levels which were maintained throughout the whole test. The C₂H₄ increased concurrently with the C₂H₆ decrease, reaching a stable level after an hour of testing. However, CH₄ levels remained approximately constant throughout the experiment. The CO and H₂ levels increased respective to their initial values, particularly the H₂. Both gases reached a maximum by the first sampling point (minute 20) and then decreased, but levelled out at a concentration higher than initial values. Finally, the CO₂ concentration decreased, reaching a minimum at minute 20; then progressively increasing back to its initial concentration by minute 60. Although similar trends in gas evolution are observed for the oxidised and dip-coated meshes, the H₂ increase and CO₂ decrease are more significant for the dip-coated materials. This could be explained by the higher amount of active sites (metal nanoparticles) achieved by impregnation and/or the different metal nanoparticle composition of the coated meshes respective to the oxidised-reduced ones *(i.e.* Ni vs. FeNi alloy).

When the Ni-Al₂O₃ is used as catalyst, the C₂H₆ and C₂H₄ are depleted to negligible levels throughout the 2 h of testing. The CH₄ concentration also decreased to negligible levels up to minute 30; continuing to stabilise at a very low concentration up to minute 100. With this catalyst, the increase of H₂ and CO levels were very noticeable, as well as the decrease of CO₂. As can be observed in Figure 5 (c), the gas stream at the outlet of the reactor is essentially a CO+H₂ mixture. All gas components continued to plateau up to minute 100, when a change of the CO, H₂, CO₂ and CH₄ trends was observed. The CO and H₂ started decreasing at the same time that the CH₄ and CO₂ started increasing, although none of the gases recover to initial concentrations.

The initial H₂/CO ratio of the gasification biomass mixture used as feedstock is 0.09. The H₂/CO ratio of the syngas obtained after the CCVD process increases to approximately 0.3, 0.5 and 0.8 when the oxidised-reduced meshes, Ni-coated meshes and Ni-Al₂O₃ were used as catalysts, respectively. With a H₂:CO ratio close to 1, the syngas produced would be more optimal for oxo-synthesis, such as the production of acetic acid for example, or as fuel in solid oxide fuel cells for electricity production. The ideal ratio for Fischer-Tropsch synthesis is 1.8-2.1, although it must be taken into account that iron-based catalysts can accept lower ratios due to their intrinsic activity towards water gas shift reaction. Moreover, if the original biomass gasification mixture is not dried, the H₂:CO ratio could be adjusted by an intrinsic water gas shift reaction.

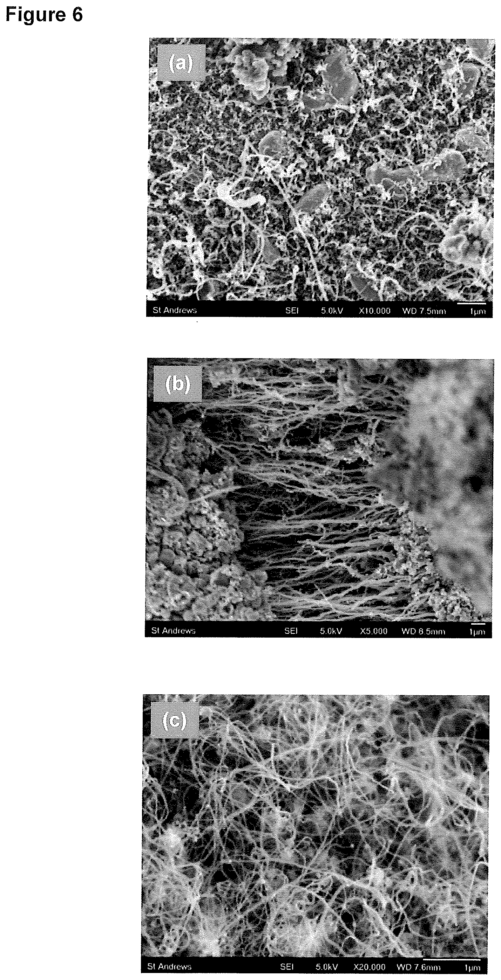

**Carbon deposits.** Carbon deposition was observed with all five catalysts during the CCVD process in these experimental conditions. The SEM micrographs of the un-purified carbon deposits obtained are shown in Figure 6. As previously for the gas analysis, a representative material of each group of the thermally and chemically modified stainless steel meshes (800C-SS316 and Ni-ES-SS316), along with the Ni-Al₂O₃, were selected. Figure 6 shows that CNTs were produced with all catalysts, forming a dense, homogeneously distributed and highly entangled net. Some areas with a more regular orientation and CNTs growing in parallel were observed with the dip-coated meshes (Fig. 6 (b)). The SEM micrographs seem to indicate that a denser CNT layer with smoother surfaces and more regular shapes, as well as less amorphous carbon, was obtained with the Al₂O₃ (Fig. 6 (c)) than with the stainless steel mesh based catalysts (Fig. 6 (a-b)).

Similar findings were observed when evaluating the detachment of the carbon deposits from both oxidised-reduced and dip-coated meshes. It was found from SEM micrographs that remaining carbon deposits were still strongly attached to the mesh surface in some areas. In general, the external part of the mesh cylinder presented less residual carbon deposits than the internal parts, despite applying cycles of ultrasonication to individual parts of the cylinder. The remaining carbon deposits attached to the mesh surface still contained a significant amount of CNTs. Around 50% recovery of the total carbon deposits was achieved for the oxidized-reduced meshes (600-SS316 and 800-SS316) *via* ultrasonication. For the dip-coated meshes (Ni-ES-SS316 and Ni-EST-SS316) around 45% recovery was accomplished by shaking and an additional 33% *via* ultrasonication, achieving an average total recovery of carbon deposits of approximately 78%. The efficiency of recovery might depend on many parameters, *i.e.* diameter of the CNTs, thinner tubes can be more easily detached, or presence of amorphous carbon.

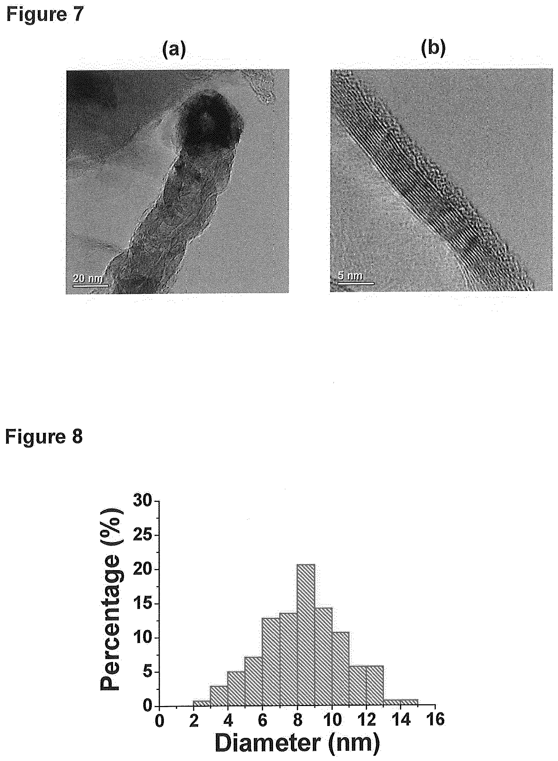

The as-produced CNTs were analysed further by TEM. Figure 7 displays some illustrative TEM and HRTEM micrographs of the CNTs obtained *via* the CCVD process with the different catalysts.

The TEM analysis showed that MWCNTs of different morphologies were obtained with all the catalysts, including open-ended CNTs (Fig. 7 (a)).

Using the HRTEM micrographs, such as the one shown in Figure 7 (b), it was possible to estimate the outer diameter and number of walls of the CNTs. However, the measurement of the actual length of the tubes was difficult to achieve due to their inherent interweaving, but was estimated to be in the range of microns. The narrower range of carbon diameters was found with the Ni-Al₂O₃, from 6 to 25 nm; whereas the diameter range of the tubes produced with the dip-coated meshes was broader, from 25 to 60 nm for Ni-ES-SS316 and from 7 to 65 nm for Ni-ETS-SS316 (the majority centred around 30-40 nm). In general, a larger outer diameter of the tubes was correlated with a higher number of walls; 14-29 for Ni-Al₂O₃, 12-43 for Ni-ES-SS316 and 23-34 for Ni-ETS-SS316.

Raman analyses of the as-produced carbon deposits were performed to evaluate the crystallinity, degree of graphitisation and purity of the CNTs. The spectrum of the carbon deposits showed four characteristics contributions of CNTs: (i) D band (~1345 cm⁻¹), (ii) G band (~1572 cm⁻¹), (iii) D' band (~1607 cm⁻¹) and (iv) G' band (~2690 cm⁻¹). The D band is related to the structural disorder within the graphite planes or the presence of impurities. The structural disorder is generally assigned to defects in the sp² bonds on the side walls of carbon nanomaterials *(i.e.* defects from vacancies, grain boundaries and finite size effects). The impurities can be related to the presence of amorphous carbon or other particles adhered to the walls. On the contrary, the G band is more related to the graphitic crystalline structure of the tubes and is due to the in-plane stretching vibrations of C-C bonds. The D' band is usually a shoulder of the G band and is also assigned to graphitic defects or disordered carbons. G' represents a two photon elastic scattering process and is representative of the graphitic features. The radial breathing mode (RBM) is a band exclusively characteristic of single and double wall carbon nanotubes (SWCNT and DWCNT) and appears in the range from 150 to 300 cm⁻¹. The absence of evident RBM peaks and strong intensities of the D, G and G' modes confirmed that the samples are mainly MWCNTs, which is consistent with the TEM analysis.

**Table 4. Raman analyses of the un-purified CNTs produced via CCVD process with the biomass gas mixture at 800 °C for various catalysts.**

| **Catalyst** | **D/G** |
|---|---|
| **800C-SS316_ultrasonication** | 0.59 |
| **Ni-ES-SS316_shaking** | 0.66 |
| **Ni-ES-SS316_ultrasonication** | 0.50 |
| **Ni-Al₂O₃** | 0.76 |

According to literature, the I_{D}/I_{G} ratio obtained from Raman is indicative of the CNT quality. Generally, it is believed that the lower this ratio, the higher the purity of CNTs. In Table 4, the averaged I_{D}/I_{G} ratios obtained for a representative material of each group of stainless steel meshes, 800C-SS316 and Ni-ES-SS316, along with the Ni-Al₂O₃ are presented.

The low I_{D}/I_{G} ratios ranging between 0.5-0.7 indicate high graphitisation, high degree of crystallinity and few defects in the tubes. Therefore, good quality CNTs have been produced, especially considering that they have not been purified and the experimental time is longer than employed in many studies - usually in the order of seconds or minutes. For the dip-coated meshes, the carbon residues obtained by shaking and the ones recovered *via* ultrasonication were analysed separately to see if any difference could be observed. As can be seen in Table 4, although the I_{D}/I_{G} ratio is low for both samples, the ratio is lower for the solids recovered after ultrasonication. This could be due to the fact that amorphous carbon is likely to be less strongly attached and, therefore, it could be easily recovered by shaking of the mesh. Moreover, the D, G, D' and G' bands appear at higher wavenumbers for the carbon deposits firstly recovered by shaking compared to the ones recovered *via* ultrasonication, indicating a variation in bond strength, as in general stronger bonds appear at lower wavenumbers.

### Conclusions

A catalytic chemical vapour deposition technique has been found to be a promising technology to achieve the upgrade of a biomass gasification mixture to syngas, along with the production of highly-valuable carbon nanotubes as a by-product. The process has been demonstrated with different cost-effective catalysts - activated stainless steel meshes and nickel impregnated alumina.

The stainless steel meshes as catalysts present advantages of low cost, easy handling for scaling up, easy processing and possibility of re-utilisation. With the alumina support, the impregnation of metal nanoparticles can be controlled and a higher loading of metal can be achieved, which would help to operate the process for longer times without replacing the material and to obtain a higher CNT yield, as it has been observed.

Similar tendencies in the gas composition are observed with the different catalysts. For the stainless steel mesh supported catalysts the reactions observed for the gas components of interest, reduction of CO₂ and increase of H₂, are much shorter than with the alumina supported catalyst due to lower metal loading and/or different metal composition. The final gas stream produced is rich in H₂ and CO, increasing the H₂/CO ratio from the initial value of 0.09 to values ranging from 0.3 to 0.8 depending on the catalyst. Moreover, with the Ni-Al₂O₃ catalyst, the CO₂ concentration is reduced by more than 75% of the starting value in the experimental conditions selected, which is very encouraging from an environmental perspective. The SEM, TEM and Raman analyses of the carbon deposits showed that the CNTs exhibit a high quality, without the use of extra purification. However, purification of the carbon nanotubes could be carried out depending on application *(i.e.* combustion in air to burn out the amorphous carbon or acid/alkali washing to dissolve the metal nanoparticles).

### Example 2

The use of a biomass gas stream to produce syngas and CNT has also been demonstrated using bi-metallic catalysts supported on γ-alumina (4 wt.%Ni - 1 wt.% Mo). Figure 8 shows the nanoparticle size distribution of the catalyst.

The CCVD process (as described in Example 1) was carried out using the γ-alumina-supported bi-metallic catalyst under various conditions, as shown in Table 5:

**Table 5. Experimental conditions evaluated for CCVD process to upgrade the biomass gas stream to syngas and CNTs using 4 wt.%Ni -1 wt.% Mo on γ-Al₂O₃ as catalyst.**

| **Experiment** | **Temperature (°C)** | **Gas flow rate (ml/min)** | **Time (min)** |
|---|---|---|---|
| **1** | 600 | 25 | 60 |
| **2** | 600 | 25 | 30 |
| **3** | 600 | 25 | 10 |
| **4** | 800 | 25 | 60 |
| **5** | 800 | 25 | 30 |
| **6** | 800 | 25 | 10 |
| **7** | 800 | 25 | 120 |

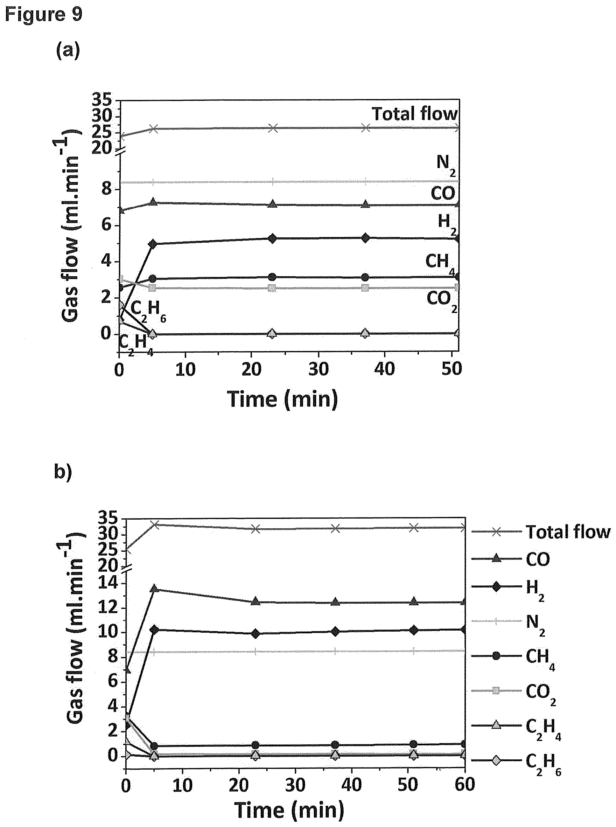

It was observed that higher testing temperatures (800 vs. 600°C) favour the production of CO and H₂ as well as CO₂ depletion to levels lower than may be quantified by the GC. This process occurs rapidly and the gas concentrations remain stable regardless of test length up to 2 h (Figure 9).

It was also observed that the experimental conditions could be used to selectively control the CNT characteristics. For the same gas flow and time period, higher temperature was found to lead to CNTs with better graphitic properties although the CNT layer is less dense than at lower testing temperatures. At same temperature and flow rate, lower reaction times were found to produce CNTs with better graphitic properties. It was also observed that high space velocities appear to favour better quality CNTs when temperature and testing time are constant.

**Table 6. Examples of D/G ratios from the Raman spectra of the un-purified carbon deposits obtained using 4 wt.%Ni - 1 wt.% Mo on γ-Al₂O₃ as catalyst under different experimental conditions.**

| **Temperature (°C)** | **Gas flow (ml/min)** | **Time (min)** | **D/G** |
|---|---|---|---|
| 600 | 25 | 60 | 1.272 |
| 600 | 25 | 30 | 1.228 |
| 800 | 25 | 60 | 1.182 |
| 800 | 25 | 30 | 0.879 |
| 800 | 25 | 120 | 1.286 |
| 800 | 50 | 120 | 0.644 |

### Summary

The CNTs were characterised as-produced, without any further purification steps. A summary of properties of the un-purified carbon deposits obtained with the different catalysts tested in both Examples 1 and 2 (including both monometallic and bimetallic) and under different experimental conditions is provided in Table 7.

**Table 7**

| CNT type | Multiwall (MWCNTs) |
|---|---|
| Min. number of walls | 12 |
| Max. number of walls | ≤50 |
| Range of CNT outer diameter (nm) | 6-65 |
| Narrowest range of CHT outer diameter (nm) | 13-26 |
| Lowest values for CNT outer diameter (nm) | 6-25 |
| Range of D/G ratio from Raman analysis | 0.5-1.3 |

## Claims

1. A method for processing a gas stream produced by gasification of biomass or waste or by Low Temperature Conversion, LTC, wherein the LTC is carried out at a temperature of 600°C or less, the gas stream comprising 1-60 vol.% CO₂; 1-60 vol.% CO; 1-40 vol.% H₂; 1-80 vol.% CH₄; 0-35 vol.% n-C₂ - n-C₆; 0-45 vol.% N₂; 0-5 vol.% O₂; 0-20 vol.% H₂O, the method comprising:
processing the waste using the Low Temperature Conversion, LTC, to produce an output gas using an LTC system, or performing the gasification of biomass or waste to produce an output gas using a gasification system;
supplying the gas stream output from the LTC or the gasification to CCVD apparatus;
utilising the gas stream in a catalytic chemical vapour deposition, CCVD, process, thereby reducing the CO₂ content of the gas stream and concomitantly producing carbon nanotubes and syngas, the CCVD process being carried out at a temperature of from 500°C to 900°C, and wherein the catalyst is a stainless steel or alumina supported catalyst the catalyst comprising a metal, metal alloy or an enriched metal in an oxide layer, and wherein the catalyst has a metal loading of from 0.1 to 30 wt%, relative to the total weight of the metal and the support;
n-C₂ - n-C₆ comprises at least one of: ethane, ethane, ethyne, propane, propene, propyne, butane, butane, butyne, pentane, pentene, pentyne, hexane, hexane or hexyne, or any combination thereof; and wherein
the CCVD process is carried out at the same temperature as the gasification or LTC process.

2. The method of claim 1, wherein the gas stream comprises H₂, N₂, CO, CO₂, CH₄ and one or more n-C₂ hydrocarbons.

3. The method of claim 1 or claim 2, wherein the gas stream comprises CO₂, CO, H₂, CH₄, C₂H₄, C₂H₆ and N₂.

4. The method of any one of claims 1 to 3, wherein the gas stream further comprises one or more gases selected from O₂, H₂O, n-C₃, n-C₄, n-C₅ and/or n-C₆ hydrocarbons.

5. The method of any preceding claim, wherein the waste comprises at least one selected from: plastics, tires, municipal waste, waste from water treatment, and/or biomass.

6. The method of any preceding claim, wherein:
the catalyst is a coated stainless steel supported catalyst having a metal loading of from 0.1 to 1.1 wt.%; or
the catalyst is an alumina supported catalyst having a metal loading of from 2.5 to 10 wt.%.

7. The method of any preceding claim, wherein the metal is nickel, iron, molybdenum, manganese, cobalt, copper, ruthenium, rhodium, palladium, iridium, platinum, chromium, tungsten, cerium, silver, gold, or mixtures or alloys thereof.

8. An apparatus for processing a gas stream produced by gasification of biomass or waste or by Low Temperature Conversion, LTC, wherein the LTC is carried out at a temperature of less than 600°C, the gas stream comprising 1-60 vol.% CO₂; 1-60 vol.% CO; 1-40 vol.% H₂; 1-80 vol.% CH₄; 0-35 vol.% n-C₂-n-C₆; 0-45 vol.% N₂; 0-5 vol.% O₂; 0-20 vol.% H₂O, the apparatus comprising:
a catalytic chemical vapour deposition, CCVD, reactor for carrying out a CCVD process and receiving a catalyst therein, the reactor having a gas inlet and a separate gas outlet and configured for reducing the CO₂ content of the gas stream and concomitantly producing carbon nanotubes and syngas;
a heat source for heating the reactor to a temperature of from 500°C to 900°C;
a supply of the gas stream in fluid communication with an outlet of a gasification or LTC system;
a catalyst in the reactor, wherein the catalyst is a stainless steel or alumina supported catalyst, the catalyst comprising a metal, metal alloy or an enriched metal in an oxide layer, and wherein the catalyst has a metal loading of from 0.1 to 30 wt%, relative to the total weight of the metal and the support;
and
a gas control system which controls the supply of the gas stream to the gas inlet of the reactor, and wherein
n-C₂ - n-C₆ comprises at least one of: ethane, ethane, ethyne, propane, propene, propyne, butane, butane, butyne, pentane, pentene, pentyne, hexane, hexane or hexyne, or any combination thereof; and
the apparatus is configured such that the CCVD process is carried out at the same temperature as the gasification or LTC process.

## Patentansprüche

1. Verfahren zum Verarbeiten eines Gasstroms, der durch Vergasung von Biomasse oder Abfällen oder durch Niedertemperaturumwandlung (LTC) produziert wird, wobei die LTC bei einer Temperatur von 600 °C oder weniger ausgeführt wird und der Gasstrom 1-60 Vol.-% CO₂; 1-60 Vol.-% CO; 1-40 Vol.-% H₂; 1-80 Vol.-% CH₄; 0-35 Vol.-% n-C₂ - n-C₆; 0-45 Vol.-% N₂; 0-5 Vol.-%O₂; 0-20 Vol.-% H₂O umfasst, wobei das Verfahren Folgendes umfasst:
Verarbeiten der Abfälle unter Verwendung von Niedertemperaturumwandlung (LTC), um unter Verwendung eines LTC-Systems ein Auslassgas zu produzieren, oder Durchführen der Vergasung von Biomasse oder Abfällen, um unter Verwendung eines Vergasungssystems ein Auslassgas zu produzieren;
Zuführen des Gasstromauslasses aus der LTC oder der Vergasung zur CCVD-Einrichtung;
Nutzen des Gasstroms in einem katalytischen chemischen Gasphasenabscheidungsprozess (CCVD-Prozess), wodurch der CO₂-Gehalt des Gasstroms reduziert und gleichzeitig Kohlenstoffnanoröhren und Synthesegas produziert wird, wobei der CCVD-Prozess bei einer Temperatur von 500 °C bis 900 °C ausgeführt wird und wobei der Katalysator ein auf Edelstahl oder Aluminiumoxid geträgerter Katalysator ist, wobei der Katalysator ein Metall, eine Metalllegierung oder ein angereichertes Metall in einer Oxidschicht umfasst und wobei der Katalysator bezogen auf das Gesamtgewicht des Metalls und des Trägers eine Metallbeladung von 0,1 bis 30 Gew.-% aufweist;
wobei n-C₂ - n-C₆ mindestens eins umfasst von: Ethan, Ethan, Ethin, Propan, Propen, Propin, Butan, Butan, Butin, Pentan, Penten, Pentin, Hexan, Hexan oder Hexin oder eine beliebige Kombination davon; und wobei
der CCVD-Prozess bei der gleichen Temperatur wie die Vergasung oder der LTC-Prozess ausgeführt wird.

2. Verfahren nach Anspruch 1, wobei der Gasstrom H₂, N₂, CO, CO₂, CH₄ und einen oder mehrere n-C₂-Kohlenwasserstoffe umfasst.

3. Verfahren nach Anspruch 1 oder Anspruch 2, wobei der Gasstrom CO₂, CO, H₂, CH₄, C₂H₄, C₂H₆ und N₂ umfasst.

4. Verfahren nach einem der Ansprüche 1 bis 3, wobei der Gasstrom weiter ein oder mehrere Gase umfasst, ausgewählt aus O₂, H₂O, n-C₃-, n-C₄-, n-C₅- und/oder n-C₆-Kohlenwasserstoffen.

5. Verfahren nach einem vorstehenden Anspruch, wobei die Abfälle mindestens eins umfassen ausgewählt aus: Kunststoffen, Reifen, Siedlungsabfällen, Abfällen aus der Wasseraufbereitung, und/oder Biomasse.

6. Verfahren nach einem vorstehenden Anspruch, wobei:
der Katalysator ein beschichteter, auf Edelstahl geträgerter Katalysator mit einer Metallbeladung von 0,1 bis 1,1 Gew.-% ist; oder
der Katalysator ein auf Aluminiumoxid geträgerter Katalysator mit einer Metallbeladung von 2,5 bis 10 Gew.-% ist.

7. Verfahren nach einem vorstehenden Anspruch, wobei das Metall Nickel, Eisen, Molybdän, Mangan, Kobalt, Kupfer, Ruthenium, Rhodium, Palladium, Iridium, Platin, Chrom, Wolfram, Cer, Silber, Gold oder Mischungen oder Legierungen davon ist.

8. Einrichtung zum Verarbeiten eines Gasstroms, der durch Vergasung von Biomasse oder Abfällen oder durch Niedertemperaturumwandlung (LTC) produziert wird, wobei die LTC bei einer Temperatur von weniger als 600 °C ausgeführt wird, wobei der Gasstrom 1-60 Vol.-% CO₂; 1-60 Vol.-% CO; 1-40 Vol.-% H₂; 1-80 Vol.-% CH₄; 0-35 Vol.-% n-C₂ - n-C₆; 0-45 Vol.-% N₂; 0-5 Vol.-% O₂; 0-20 Vol.-% H₂O umfasst, wobei die Einrichtung Folgendes umfasst:
einen Reaktor zur katalytischen chemischen Gasphasenabscheidung (CCVD) zum Ausführen eines CCVD-Prozesses und zum Aufnehmen eines Katalysators darin, wobei der Reaktor einen Gaseinlass und einen separaten Gasauslass aufweist und zum Reduzieren des CO₂-Gehalts des Gasstroms und gleichzeitigen Produzieren von Kohlenstoffnanoröhren und Synthesegas konfiguriert ist;
eine Wärmequelle zum Erwärmen des Reaktors auf eine Temperatur von 500 °C bis 900 °C;
eine Zufuhr des Gasstroms in strömungstechnischer Kommunikation mit einem Auslass eines Vergasungs- oder LTC-Systems;
einen Katalysator in dem Reaktor, wobei der Katalysator ein auf Edelstahl oder Aluminiumoxid geträgerter Katalysator ist, wobei der Katalysator ein Metall, eine Metalllegierung oder ein angereichertes Metall in einer Oxidschicht umfasst und wobei der Katalysator bezogen auf das Gesamtgewicht des Metalls und des Trägers eine Metallbeladung von 0,1 bis 30 Gew.-% aufweist;
und
ein Gassteuersystem, das die Zufuhr des Gasstroms zu dem Gaseinlass des Reaktors steuert, und wobei
n-C₂ - n-C₆ mindestens eins umfasst von: Ethan, Ethan, Ethin, Propan, Propen, Propin, Butan, Butan, Butin, Pentan, Penten, Pentin, Hexan, Hexan oder Hexin oder eine beliebige Kombination davon; und
die Einrichtung derart konfiguriert ist, dass der CCVD-Prozess bei der gleichen Temperatur wie die Vergasung oder der LTC-Prozess ausgeführt wird.

## Revendications

1. Procédé de traitement d'un flux de gaz produit par une gazéification de biomasse ou de déchets, ou par une conversion à basse température, CBT, dans lequel la CBT est réalisée à une température de 600 °C ou moins, le flux de gaz comprenant 1-60 % en volume de CO₂ ; 1-60 % en volume de CO ; 1-40 % en volume de H₂ ; 1-80 % en volume de CH₄ ; 0-35 % en volume de n-C₂ - n-C₆ ; 0-45 % en volume de N₂ ; 0-5 % en volume d'O₂ ; 0-20 % en volume de H₂O, le procédé comprenant :
le traitement des déchets à l'aide de la conversion à basse température, CBT, pour produire un gaz de sortie à l'aide d'un système de CBT, ou la réalisation de la gazéification de biomasse ou de déchets pour produire un gaz de sortie à l'aide d'un système de gazéification ;
la fourniture du flux de gaz issu de la CBT ou de la gazéification à l'appareil de CCVD ;
l'utilisation du flux de gaz dans un processus de dépôt chimique en phase vapeur catalytique, CCVD, ce qui permet de réduire la teneur en CO₂ du flux de gaz et de produire simultanément des nanotubes de carbone et du gaz de synthèse, le processus de CCVD étant réalisé à une température de 500 °C à 900 °C et dans lequel le catalyseur est un catalyseur supporté sur de l'acier inoxydable ou l'alumine, le catalyseur comprenant un métal, un alliage métallique ou un métal enrichi dans une couche d'oxyde et dans lequel le catalyseur présente une charge en métaux de 0,1 à 30 % en poids, par rapport au poids total du métal et du support ;
n-C₂ - n-C₆ comprend au moins un parmi : l'éthane, l'éthane, l'éthyne, le propane, le propène, le propyne, le butane, le butane, le butyne, le pentane, le pentène, le pentyne, l'hexane, l'hexane ou l'hexyne, ou n'importe quelle combinaison de ceux-ci ; et dans lequel
le processus de CCVD est réalisé à la même température que le processus de gazéification ou de CBT.

2. Procédé selon la revendication 1, dans lequel le flux de gaz comprend H₂, N₂, CO, CO₂, CH₄ et un ou plusieurs hydrocarbures n-C₂.

3. Procédé selon la revendication 1 ou la revendication 2, dans lequel le flux de gaz comprend CO₂, CO, H₂, CH₄, C₂H₄, C₂H₆ et N₂.

4. Procédé selon l'une quelconque des revendications 1 à 3, dans lequel le flux de gaz comprend en outre un ou plusieurs gaz choisis parmi O₂, H₂O, des hydrocarbures en n-C₃, en n-C₄, en n-C₅ et/ou en n-C₆.

5. Procédé selon une quelconque revendication précédente, dans lequel les déchets comprennent au moins un parmi : des plastiques, des pneus, des déchets municipaux, des déchets issus du traitement des eaux, et/ou une biomasse.

6. Procédé selon une quelconque revendication précédente, dans lequel :
le catalyseur est un catalyseur supporté sur de l'acier inoxydable revêtu, présentant une charge en métaux de 0,1 à 1,1 % en poids ; ou
le catalyseur est un catalyseur supporté sur l'alumine présentant une charge en métaux de 2,5 à 10 % en poids.

7. Procédé selon une quelconque revendication précédente, dans lequel le métal est le nickel, le fer, le molybdène, le manganèse, le cobalt, le cuivre, le ruthénium, le rhodium, le palladium, l'iridium, le platine, le chrome, le tungstène, le cérium, l'argent, l'or, ou des mélanges ou alliages de ceux-ci.

8. Appareil destiné au traitement d'un flux de gaz produit par une gazéification de biomasse ou de déchets, ou par une conversion à basse température, CBT, dans lequel la CBT est réalisée à une température inférieure à 600 °C, le flux de gaz comprenant 1-60 % en volume de CO₂ ; 1-60 % en volume de CO ; 1-40 % en volume de H₂ ; 1-80 % en volume de CH₄ ; 0-35 % en volume de n-C₂ - n-C₆ ; 0-45 % en volume de N₂ ; 0-5 % en volume d'O₂ ; 0-20 % en volume de H₂O, l'appareil comprenant :
un réacteur de dépôt chimique en phase vapeur catalytique, CCVD, pour réaliser un procédé de CCVD et recevoir un catalyseur dans celui-ci, le réacteur présentant une entrée de gaz et une sortie de gaz distincte et étant configuré pour réduire la teneur en CO₂ du flux de gaz et produire simultanément des nanotubes de carbone et du gaz de synthèse ;
une source de chaleur pour chauffer le réacteur à une température de 500 °C à 900 °C ;
une alimentation en flux de gaz en communication fluidique avec une sortie d'un système de gazéification ou de CBT ;
un catalyseur dans le réacteur, dans lequel le catalyseur est un catalyseur supporté sur de l'acier inoxydable ou l'alumine, comprenant un métal, un alliage métallique ou un métal enrichi dans une couche d'oxyde, et dans lequel le catalyseur présente une charge en métaux de 0,1 à 30 % en poids, par rapport au poids total du métal et du support ;
et
un système de régulation de gaz qui régule la fourniture du flux de gaz à l'entrée de gaz du réacteur, et dans lequel
n-C₂ - n-C₆ comprend au moins un parmi : l'éthane, l'éthane, l'éthyne, le propane, le propène, le propyne, le butane, le butane, le butyne, le pentane, le pentène, le pentyne, l'hexane, l'hexane ou l'hexyne, ou n'importe quelle combinaison de ceux-ci ; et
l'appareil est configuré de telle sorte que le processus de CCVD soit réalisé à la même température que le processus de gazéification ou de CBT.
